# EUROPÄISCHE PATENTANMELDUNG

(11) **EP 1 930 291 A2**
(43) Veröffentlichungstag der Anmeldung: **11.06.2008**
(21) Anmeldenummer: 07019786.8
(22) Anmeldetag: 10.10.2007
(51) Int. Cl.: B81C 1/00

(54) **Halbleiterbauelement mit Sensoren und Verfahren zum Herstellen eines solchen**

(30) Priorität: 04.12.2006 DE 102006057384
(71) Anmelder: Micronas GmbH, 79108 Freiburg i. Br. (DE); Micronas Holding GmbH, 79108 Freiburg i.Br. (DE)
(72) Erfinder: Lehmann, Mirko, Dr. rer nat., 9642 Ebnat-Kappel (CH); Sieben, Ulrich, Dr.rer. nat., 79279 Vörstetten (DE); Burghartz, Joachim, Prof. Dr., 70771 Leinfelden-Echterdingen (DE)
(74) Vertreter: Huwer, Andreas

(57) **Zusammenfassung**

Bei einem Verfahren zum Herstellen eines Halbleiterbauelements (1), das mindestens zwei Sensoren (4, 4a, 4b, 4c) aufweist wird ein sich in einer Ebene erstreckender Halbleiterchip (3) bereitgestellt, in den die Sensoren (4, 4a, 4b, 4c) mit Abstand zueinander integriert sind. Zumindest in einem zwischen den Sensoren (4, 4a, 4b, 4c) befindlichen Verformungsbereich (7) des Halbleiterchips (3) ist die Wandstärke des Halbleiterchips (3) derart gewählt, dass der Verformungsbereich (7) biegeverformbar ist. Die Sensoren (4, 4a, 4b, 4c) werden mit ihren Erstreckungsebenen unter Biegeverformung des Verformungsbereichs (7) relativ zueinander verschwenkt und in dieser Lage relativ zueinander fixiert.

## Beschreibung

Die Erfindung betrifft ein Verfahren zum Herstellen eines Halbleiterbauelements, das mindestens zwei Sensoren aufweist, bei welchem Verfahren ein in einer Ebene erstreckender Halbleiterchip bereitgestellt wird. Ferner bezieht sich die Erfindung auf ein Halbleiterbauelement mit mindestens zwei mit Abstand zueinander angeordneten Sensoren, die mit ihren Erstreckungsebenen verkippt zueinander angeordnet an einem Träger angeordnet sind.

Ein derartiges Verfahren zum Herstellen eines zwei Magnetfeld-Sensoren aufweisenden Halbleiterbauelements ist aus US 2004/0103530 A1 bekannt. Bei dem Verfahren werden zunächst zwei sich jeweils in einer Ebene erstreckende Halbleiterchips bereitgestellt, in die ein Magnetfeld-Sensor integriert ist. Die Magnetfeld-Sensoren sind jeweils in einer durch die Ebene des ihnen zugeordneten Halbleiterchips bestimmten Messrichtung für einen magnetischen Fluss empfindlich, während sie für einen magnetischen Fluss, der senkrecht zu der Messrichtung verläuft, unempfindlich sind. Damit der magnetische Fluss dennoch in rechtwinklig zueinander verlaufenden Richtungen gemessen werden kann, werden die Magnetfeld-Sensoren mit ihren Erstreckungsebenen verkippt zueinander an einem Frame angeordnet. Dazu wird zunächst ein in einer Ebene verlaufender Frame bereitgestellt, der zwei laschenförmige Teilbereiche aufweist, an denen die Magnetfeld-Sensoren mit Abstand zueinander montiert und über Bonddrähte mit an dem Frame vorgesehenen Kontaktelementen verbunden werden. Danach werden die laschenförmigen Teilbereiche in zueinander entgegengesetzte Richtungen derart verbogen, dass die Magnetfeld-Sensoren relativ zueinander verschwenken und mit ihren Erstreckungsebenen verkippt zueinander angeordnet sind. Dann werden die Sensoren mit Kunststoff umspritz. Das Verfahren hat den Nachteil, dass die Magnetfeld-Sensoren nur unter einem relativ kleinen Winkel zueinander geneigt sind, da sich der von den Bonddrähten zu überbrückende Abstand beim Verbiegen der laschenförmigen Teilbereiche verändern. Das Verfahren hat außerdem den Nachteil, dass sich über Bonddrähte keine schnellen Signale für die Kommunikation zwischen den Sensoren oder zu einer Auswerteeinrichtung übertragen lassen.

Ferner können beim Verbiegen der laschenförmigen Teilbereiche Toleranzen auftreten, die zu Positionierungsungenauigkeiten der Sensoren führen können.

Es besteht deshalb die Aufgabe, ein Verfahren der eingangs genannten Art zu schaffen, bei dem die Sensoren kostengünstig und mit großer Präzision mit ihren Erstreckungsebenen in quer zueinander verlaufenden Richtungen und/oder in unterschiedlichen Ebenen angeordnet werden können. Außerdem besteht die Aufgabe, ein Halbleiterbauelement der eingangs genannten Art anzugeben, das kostengünstig herstellbar ist und eine hohe Messgenauigkeit ermöglicht.

Diese Aufgabe wird bezüglich des Verfahrens dadurch gelöst, dass die Sensoren mit Abstand zueinander in den Halbleiterchip integriert sind, dass zumindest in einem zwischen den Sensoren befindlichen Verformungsbereich des Halbleiterchips der Querschnitt des Halbleiterchips derart gewählt wird, dass der Verformungsbereich biegeverformbar ist, dass die Sensoren mit ihren Erstreckungsebenen unter Biegeverformung des Verformungsbereichs relativ zueinander verschwenkt und/oder verkippt und/oder verdreht und/oder mit Ihren Erstreckungsebenen parallel zueinander versetzt werden.

In vorteilhafter Weise ist es dadurch möglich, die Sensoren und gegebenenfalls eine damit elektrisch verbundene Auswerte- und/oder Ansteuereinrichtung mittels eines Standard-Halbleiterprozesses kostengünstig in einen einzigen Halbleiterchip zu integrieren. Mittels des Verformungsbereichs können die Sensoren bei der Montage an einem Träger mit großer Präzision in eine gewünschte Lage relativ zueinander positioniert werden. Bei einem entsprechend dünnen Verformungsbereich lässt sich dieser mit geringem Radius biegen. In dem für die Biegeverformung vorgesehenen Bereich wird die Wandstärke bevorzugt so groß gewählt, dass auch in diesem Bereich Leiterbahnen, elektronische Bauelemente und/oder aktive Schaltungsteile angeordnet werden können. Dies kann für die Kommunikation zwischen den gegeneinander verschwenkten Bereichen des Chips notwenig sein. Mit dem Verfahren lässt sich also eine dreidimensionale, in einen Halbleiterchip integrierte Sensorschaltung herstellen. Die Sensoren sind bevorzugt baugleich. Es ist aber auch möglich, dass auf dem Halbleiterchip unterschiedliche Sensoren angeordnet sind.

Bei einer zweckmäßigen Ausführungsform der Erfindung werden die Sensoren in der verschwenkten, verkippten, verdrehten und/oder parallel zueinander versetzten Lage relativ zueinander fixiert. Die Sensoren sind also bezüglich ihrer Lage statisch zueinander angeordnet.

Bei einer anderen Ausgestaltung der Erfindung werden die Sensoren in der verschwenkten, verkippten, verdrehten und/oder parallel zueinander versetzten Lage derart angeordnet, dass sie sich unter dem Einfluss einer Kraft in verschiedene Richtungen relativ zueinander verdrehen und/oder zu Schwingungen angeregt werden können. Die Sensoren sind dann bezüglich ihrer Lage dynamisch zueinander angeordnet.

Bei einer vorteilhaften Ausführungsform der Erfindung ist der Winkel, um den die Sensoren relativ zueinander verschwenkt, verkippt und/oder verdreht werden, betragsmäßig größer als 0,5°, insbesondere größer als 3°, gegebenenfalls größer als 5° und bevorzugt größer als 10°. Es sind aber auch noch größere Winkel denkbar, nämlich mindestens 20°, insbesondere mindestens 60° und sogar mindestens 90°.

Vorteilhaft ist, wenn der Halbleiterchip eine längliche, vorzugsweise rechteckige Form aufweist, wenn die Sensoren in Längserstreckungsrichtung des Halbleiterchips voneinander beabstandet sind, und wenn die Sensoren derart verschwenkt werden, dass mindestens drei Sensoren auf einer von einer geraden Linie abweichenden Linie, insbesondere auf einer Kreislinie angeordnet sind. Dabei können die Sensoren Magnetfeldsensoren, insbesondere Hallsensoren sein. Mit Hilfe des Halbleiterbauelements kann dann z.B. die Lage und/oder Bewegung eines stückweise magnetisierten Rades, beispielsweise des Rotors eines Servomotors oder Schrittmotors detektiert werden. Der Halbleiterchip kann auch stückweise gebogen werden.

Bei einer bevorzugten Ausführungsform der Erfindung sind mindestens drei Sensoren in den Halbleiterchip integriert, wobei zwischen einem ersten Sensor und einem zweiten Sensor ein erster Verformungsbereich und zwischen dem ersten Sensor und einem dritten Sensor ein zweiter Verformungsbereich erzeugt werden, und wobei der erste Sensor und der zweite Sensor durch Biegeverformen des ersten Verformungsbereichs um eine erste Achse relativ zueinander verschwenkt werden, und wobei der erste Sensor und der dritte Sensor durch Biegeverformen des zweiten Verformungsbereichs um eine zweite, quer zu der ersten Achse verlaufende Achse relativ zueinander verschwenkt werden Mit dem Halbleiterbauelement kann dann eine physikalische Größe, insbesondere ein Magnetfeld, dreidimensional gemessen werden.

Zweckmäßigerweise wird bei dem erfindungsgemäßen Verfahren ein Wafer bereitgestellt, der mehrere einstückig miteinander verbundene Halbleiterchips hat, die jeweils mindestens zwei Sensoren und wenigstens einen Verformungsbereich aufweisen, wobei die Halbleiterchips von dem Wafer abgetrennt werden, bevor die Sensoren der einzelnen Halbleiterchips mit ihren Erstreckungsebenen unter Biegeverformung des Verformungsbereichs relativ zueinander verschwenkt werden. Es können also eine Vielzahl von biegbaren Sensor-Halbleiterchips auf einem Wafer beispielsweise mittels eines Standard-Halbleiterprozesses kostengünstig hergestellt und danach entsprechend der jeweils gewünschten Anordnung der auf den Halbleiterchips befindlichen Sensoren biegeverformt werden.

Vorteilhaft ist, wenn die Wandstärke des Wafers im Bereich der Halbleiterchips z.B. durch Atzen gegenüber einem daran angrenzenden Waferbereich reduziert wird und wenn die Halbleiterchips entlang der Außenkonturen der die reduzierte Wandstärke aufweisenden Bereiche des Wafers aus diesem herausgetrennt werden. Die Halbleiterchips lassen sich dann mit geringer Kraft aus dem Waferverbund heraustrennen.

Bezüglich des Halbleiterbauelements wird die vorstehend genannte Aufgabe dadurch gelöst, dass die Sensoren in denselben Halbleiterchip integriert sind, und dass der Halbleiterchip zumindest zwischen den Sensoren einen Verformungsbereich aufweist, der einen von einer geraden Ebene abweichenden, gekrümmten Verlauf hat und die Sensoren direkt oder indirekt über mindestens einen ebenen Halbleiterbereich einstückig miteinander verbindet. Dabei ist es sogar möglich, dass in dem Verformungsbereich elektrische Verbindungsleitungen und/oder aktive Halbleiterelemente angeordnet sind. Auf dem Halbleiterchip ist vorzugsweise ein einziger Ausgang vorgesehen, über den die Messsignale aller auf dem Halbleiterchip befindlicher Sensoren ausgeben werden können.

Vorteilhafte Ausgestaltungen der Erfindung sind in den Unteransprüchen beschrieben.

Bei einer bevorzugten Ausführungsform der Erfindung weist der Halbleiterchip im Bereich der Sensoren eine größere Wandstärke auf als in dem Verformungsbereich. Dadurch können auch solche Sensoren in den Halbleiterchip integriert werden, bei denen die erforderliche Mindestdicke des Halbleitersubstrats größer ist als die Dicke des Verformungsbereichs. Dies kann beispielsweise bei einem Beschleunigungssensor der Fall sein, wenn die Masse groß ist.

Bei einer vorteilhaften Ausgestaltung der Erfindung sind mindestens zwei Sensoren über einen als Torsionssteg ausgestalteten Verformungsbereich miteinander verbunden. Dabei weist der Verformungsbereich eine längliche, dünne, fadenartige oder stabförmige Form auf

Vorteilhaft ist, wenn der Träger einen dem Verlauf des Halbleiterchips folgenden, gekrümmten Verlauf aufweist und an mehreren voneinander beabstandeten Stellen dieses Verlaufs an dem Halbleiterchip zur Anlage kommt. Die Sensoren können dadurch mit großer Präzision relativ zueinander positioniert werden. Die Sensoren werden bevorzugt plan gegen entsprechende Anlageflächen des Trägers positioniert. Das Fixieren der Sensoren an dem Träger kann mit Hilfe von Klebstoff erfolgen.

Bei einer bevorzugten Ausgestaltung der Erfindung weist der Halbleiterchip mindestens drei Sensoren auf, wobei zwischen einem ersten Sensor und einem zweiten Sensor ein erster Verformungsbereich und zwischen dem einem ersten Sensor und einem dritten Sensor ein zweiter Verformungsbereich angeordnet sind, und wobei der erste Sensor und der zweite Sensor mit ihren Erstreckungsebene quer zueinander und jeweils quer zur Erstreckungsebene des dritten Sensors angeordnet sind. Mit Hilfe des Halbleiterbauelements kann dann eine physikalische Größe dreidimensional gemessen werden.

Bei einer besonders vorteilhaften Ausgestaltung der Erfindung ist in den Halbleiterchip eine Auswerte- und/oder Ansteuereinrichtung integriert, die über in den Halbleiterchip integrierte elektrische Verbindungsleitungen mit den Sensoren verbunden ist. Die aus der Auswerte- und/oder Ansteuereinrichtung und den Sensoren bestehende elektrische Schaltung ist dann kostengünstig als eine einzige integrierte Schaltung herstellbar.

Der Träger ist bevorzugt ein Teil eines Frames, der mehrere voneinander beabstandete elektrisch leitende Teilbereiche aufweist, die mit Anschlussstellen des Halbleiterchips elektrisch verbunden sind. Der Träger erfüllt dann eine Doppelfunktion und dient außer zum Positionieren der Sensoren auch zum Kontaktieren des Halbleiterchips.

Der Halbleiterchip und die elektrisch leitenden Teilbereiche des Frames können über Bonddrähte und/oder Flip-Chip-Verbindungen elektrisch miteinander verbunden sein. Zwischen dem Frame und dem Halbleiterchip kann bereichsweise eine elektrisch isolierende Schicht angeordnet sein.

Nachfolgend sind Ausführungsbeispiele der Erfindung anhand der Zeichnung näher erläutert. Es zeigen:
- Fig. 1: einen Halbleiter-Wafer,
- Fig. 2: einen Teilquerschnitt durch einen Wafer,
- Fig. 3: eine Aufsicht auf ein erstes Ausführungsbeispiel eines Halbleiterchips,
- Fig. 4: eine Ansicht eines zweiten Ausführungsbeispiels eines Halbleiterchips, der an voneinander beabstandeten Stellen einem Träger fixiert ist,
- Fig. 5: eine Aufsicht auf ein drittes Ausführungsbeispiel eines Halbleiterchips,
- Fig. 6 u. 7: Seitenansichten des dritten Ausführungsbeispiels,
- Fig. 8: ein viertes Ausführungsbeispiel eines Halbleiterchips, wobei der Halbleiterchip einen Torsionssteg hat,
- Fig. 9: ein fünftes Ausführungsbeispiel eines Halbleiterchips, bei dem ein Sensor an zwei Torsionsstegen aufgehängt ist,
- Fig. 10: ein sechstes Ausführungsbeispiel eines einen Torsionssteg aufweisenden Halbleiterchips und
- Fig. 11: ein weiteres Ausführungsbeispiel eines einen Torsionssteg aufweisenden Halbleiterchips.

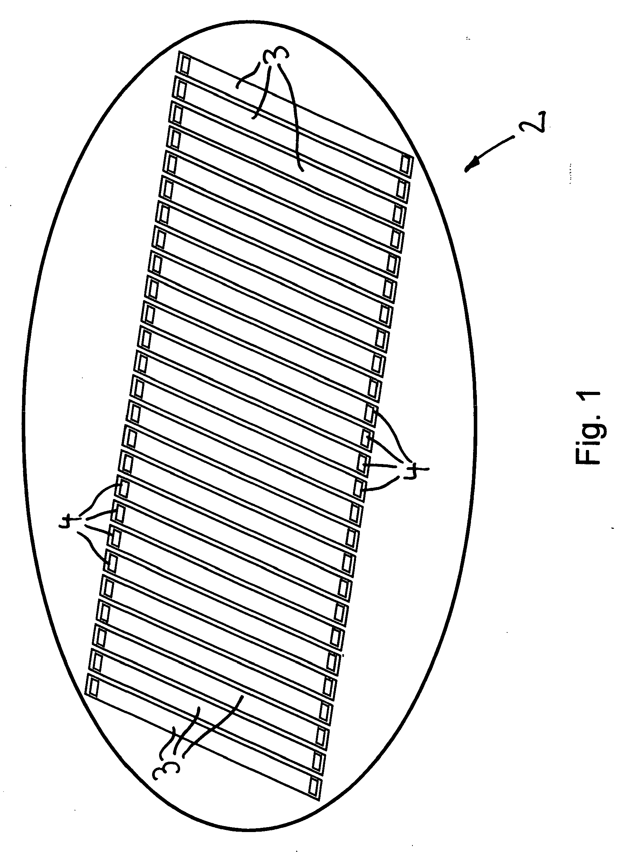

Bei einem Verfahren zum Herstellen eines Halbleiterbauelements 1 wird ein in Fig. 1 dargestellter Halbleiter-Wafer 2 bereitgestellt, in dessen Oberfläche mit an sich bekannten Methoden der Halbleiterfertigung eine Vielzahl von Sensoren für Halbleiterchips 3 integriert werden. Die Halbleiterchips 3 haben jeweils zwei baugleiche direktionale Sensoren 4, beispielsweise Hall-Sensoren. Die Sensoren 4 sind mit ihren Erstreckungsebenen parallel zur Ebene des Halbleiter-Wafers 2 angeordnet. Die Messrichtung der Sensoren verläuft rechtwinklig zur Ebene des Halbleiter-Wafers 2. Der Wafer ist in Fig. 1 nur schematisch dargestellt und kann abweichend von Fig. 1 mehrere vorzugsweise parallel nebeneinander angeordnete Reihen aufweisen, in denen jeweils Sensoren 3 für eine Vielzahl von Halbleiterchips 3 nebeneinander angeordnet sind.

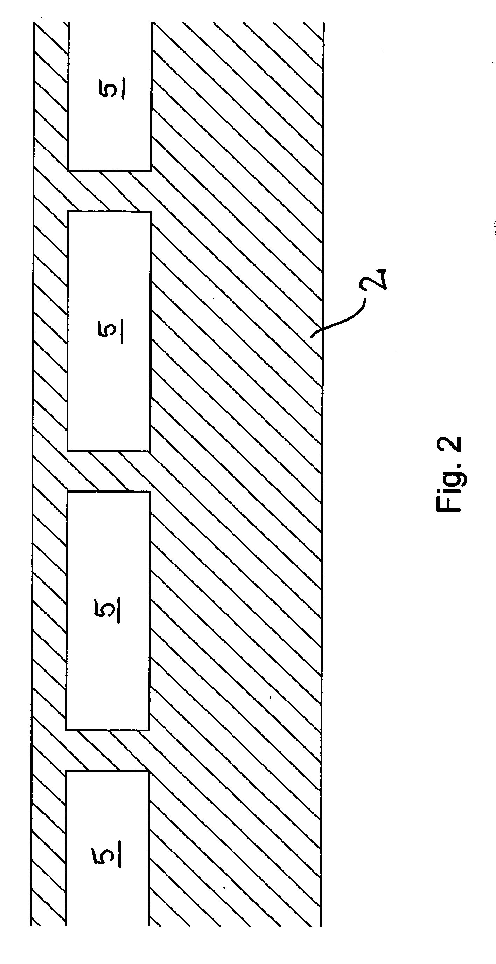

Wie in Fig. 2 erkennbar ist, hat der Halbleiter-Wafer 2 eine Vielzahl von Kavitäten 5, die unter Oberflächenbereichen des Wafers 2 angeordnet sind, in welche die Halbleiterchips 2 integriert werden sollen. Sie verlaufen mit ihrer Haupterstreckungsebene etwa parallel zur Erstreckungsebene des Wafers 2. Im Bereich der Kavitäten hat der Wafer 2 eine gegenüber seitlich daran angrenzenden Waferbereichen deutlich reduzierte Wandstärke.

Nachdem die Sensoren 4 in den Wafer 2 integriert wurden, werden die späteren Halbleiterchips 3 entlang der Außenkonturen der die reduzierten Wandstärke aufweisenden Bereiche des Wafers 2 aus diesem herausgetrennt und vereinzelt. Das Heraustrennen der Halbleiterchips 3 kann beispielsweise durch Aufbringen von Druck auf die Oberfläche der Halbleiterchips 3 erfolgen. Dabei treten an den Rändern der Halbleiterchips 3 Scherkräfte auf, welche die Halbleiterchips 3 von den daran angrenzenden Waferbereichen abtrennen.

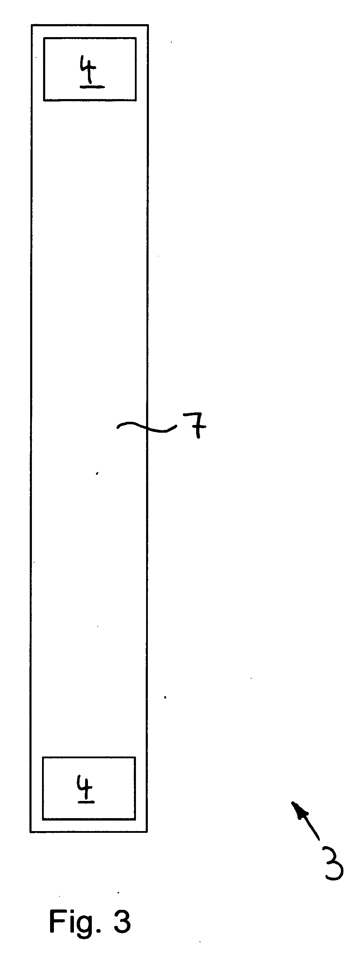

In Fig. 3 ist erkennbar, dass die Halbleiterchips 3 eine längliche, etwa rechteckige Form aufweisen und dass die Sensoren 4 an den voneinander beabstandeten Endbereichen der Halbleiterchips 3 plan in diese integriert sind. Die Wandstärke der Halbleiterchips 3 ist derart dünn gewählt, dass die Halbleiterchips 3 elastisch und/oder plastisch biegeverformbar sind.

Die einzelnen Halbleiterchips 3 werden nun mit ihren Erstreckungsebenen unter Biegeverformung des Halbleiterwerkstoffs derart quer zur Erstreckungsebene relativ zueinander verschwenkt, dass die Sensoren 4 mit ihren Erstreckungsebenen quer zueinander angeordnet sind. In dieser Lage werden die Sensoren 4 an einem Träger 6 relativ zueinander fixiert, beispielsweise indem die Sensoren 4 auf den Träger 6 aufgeklebt werden. Der Halbleiterchip 3 wird über in der Zeichnung nicht näher dargestellte Bonddrähte mit elektrischen Anschlusskontakten verbunden. Das so erhaltene Halbleiterbauelement 1 kann dann beispielsweise in ein in der Zeichnung nicht näher dargestelltes Bauelementegehäuse eingebaut oder mit Kunststoff umspritzt oder mit einer sich verfestigenden, fließfähigen Vergussmasse ummantelt werden.

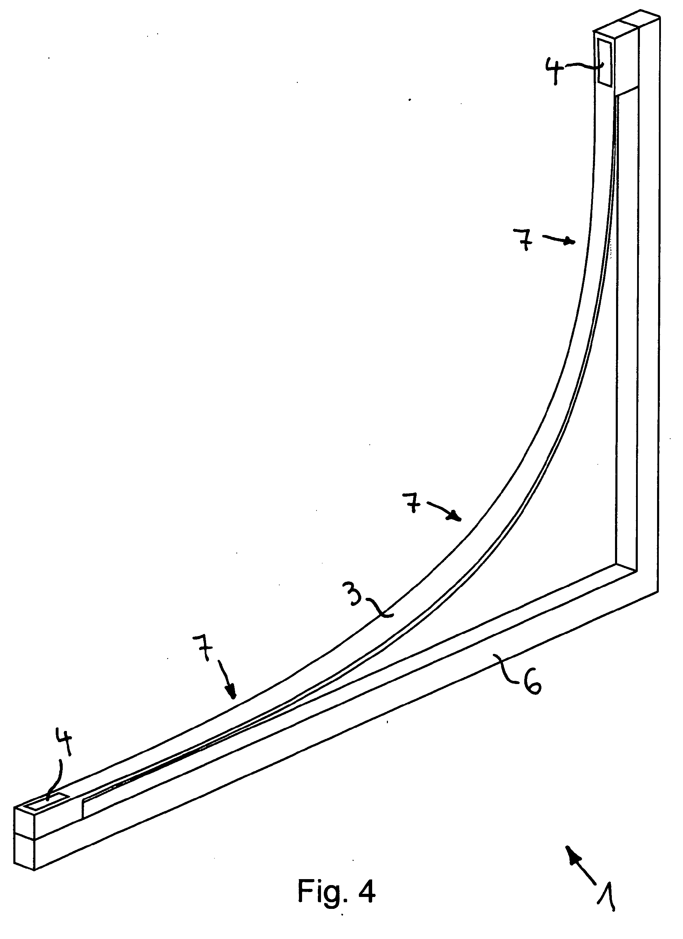

Bei dem in Fig. 4 gezeigten Ausführungsbeispiel weist der Halbleiterchip 3 zwischen den Sensoren 4 einen Verformungsbereich 7 auf, der die Sensoren 4 einstückig miteinander verbindet. In dem Verformungsbereich 7 hat der Halbleiterchip 3 eine geringere Wandstärke auf als in den von den Sensoren 4 überdeckten Bereichen. Der Verformungsbereich 7 hat einen von einer geraden Ebene abweichenden, bogenförmig gekrümmten Verlauf An den Verformungsbereich 7 schließt sich beidseits ein etwa ebener Chipbereich an, in dem jeweils ein Sensor 4 angeordnet ist. Die Rückseite der Sensoren 4 ist gegen den Träger 6 positioniert und mit diesem beispielsweise über eine Klebstoffschicht oder eine Bondverbindung fest verbunden.

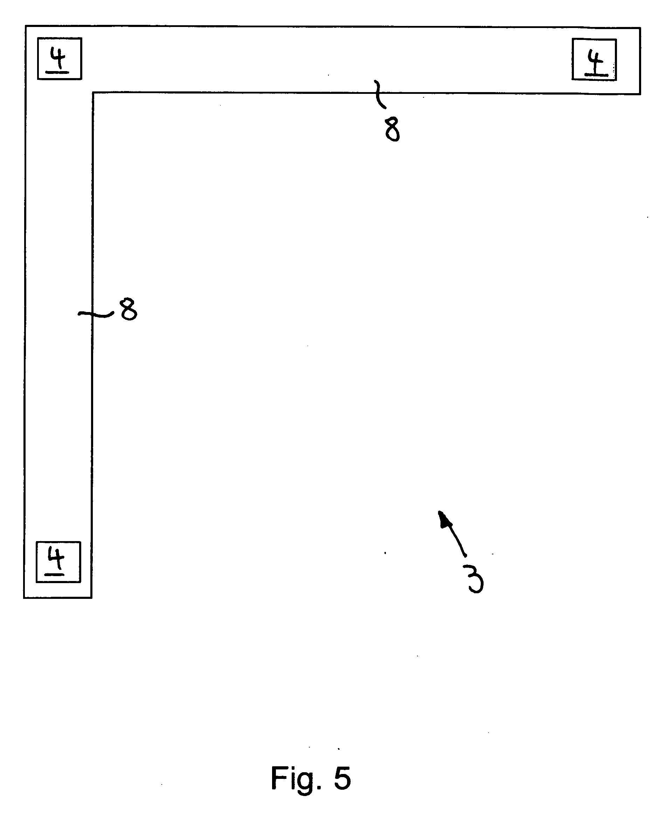

Bei dem in Fig. 5 bis 7 gezeigten Ausführungsbeispiel ist der Halbleiterchip 3 L-förmig ausgestaltet. Er weist an den beiden freien Endbereichen seiner L-Schenkel 8 jeweils einen direktionalen Sensor 4 und im Bereich der Verbindungsstelle der L-Schenkel 8 einen weiteren direktionalen Sensor 3 auf Die Wandstärke des Halbleiterchips 3 ist so gering dimensioniert, dass der Halbleiterchip 3 biegbar ist.

Solange der Halbleiterchip 3 noch mit dem Wafer 2 verbunden ist, sind die L-Schenkel 8 in der Waferebene angeordnet. Dabei verlaufen die Erstreckungsebenen der Sensoren 4 in der Waferebene. Nach dem Herauslösen aus dem Wafer 2 werden die L-Schenkel 8 bogenförmig in unterschiedliche Richtungen gekrümmt. Dabei verschwenken die beiden an den freien Enden der L-Schenkel 8 angeordneten Sensoren 4 jeweils um 90° zu dem im Bereich der Verbindungsstelle der L-Schenkel 8 angeordneten Sensor 3 aus dessen Erstreckungsebene heraus. Die Sensoren 4 können auch um einen kleineren Winkel als 90° relativ zueinander verschwenkt werden, zum Beispiel nur um 1 ° oder 2° oder sogar weniger, wenn sie ausreichend empfindlich sind. Die direktionalen Sensoren 4 sind nur für solche Signale empfindlich, die keinerlei Vektorkomponente senkrecht zu ihrer Vorzugsrichtung haben, also sehr präzise in der Ebene des Sensors 4 liegen. Bereits bei geringen Verschwenkungen tritt aber eine (kleine) Komponente senkrecht zur Ebene des Sensors 4 auf

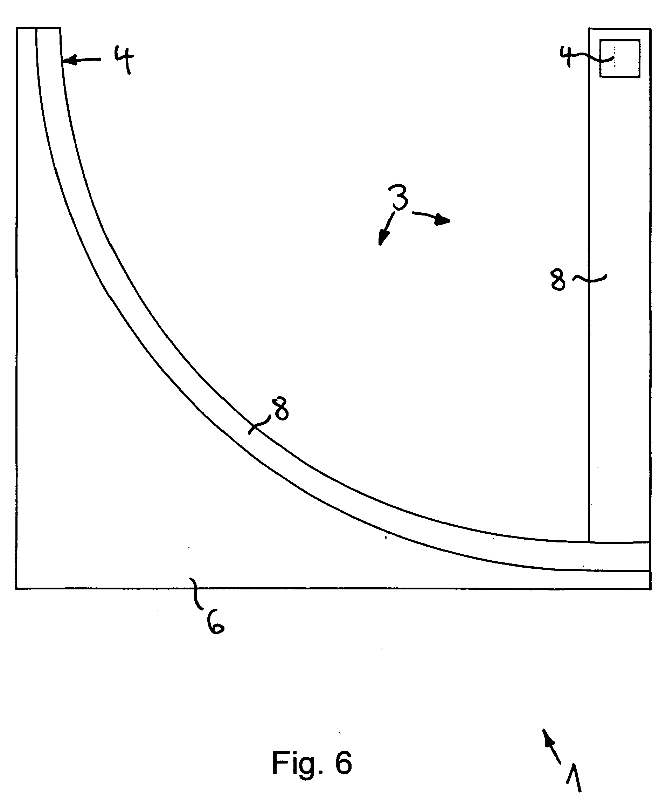

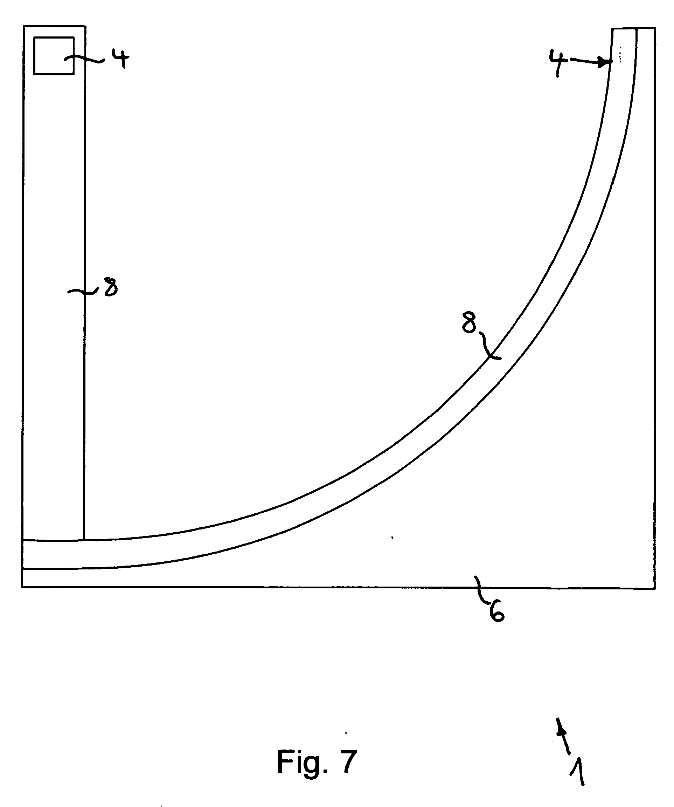

Nun werden die Sensoren 3 an dem Träger 6 fixiert. In Fig. 6 und 7 ist erkennbar, dass die drei Sensoren 6 derart in quer zueinander verlaufenden Ebenen angeordnet sind, dass sie mit ihren Messrichtungen ein kartesisches Koordinatensystem aufspannen.

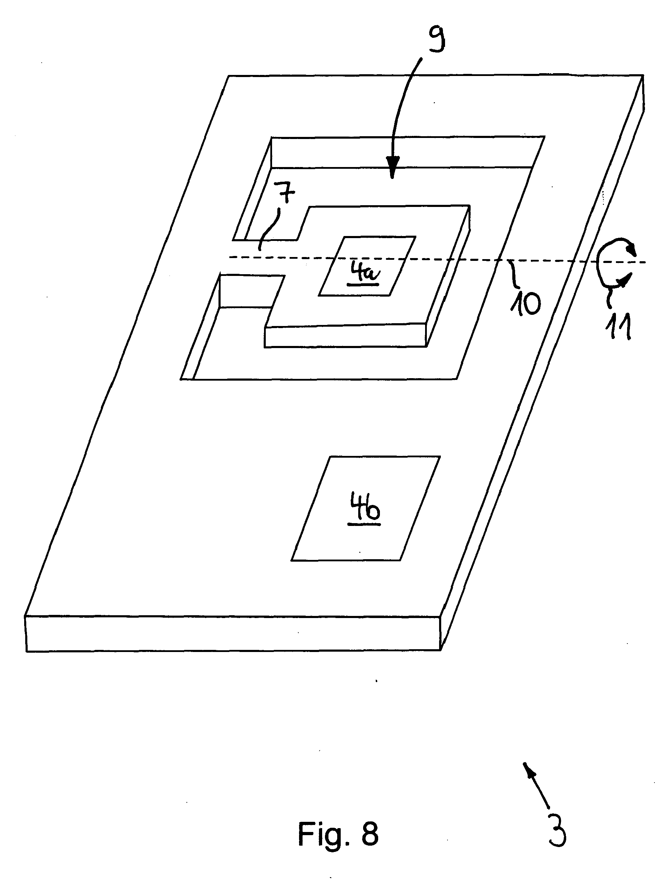

Bei dem in Fig. 8 gezeigten Ausführungsbeispiel sind in den Halbleiterchip 3 zwei direktionale Sensoren 4a, 4b integriert. Um einen dieser Sensoren 4a herum wird ein etwa C-förmiger Wandungsdurchbruch 9 in den Halbleiterchip 3 eingebracht. Der andere Sensor 4b ist außerhalb des von dem Wandungsdurchbruch 9 umgrenzten Bereichs angeordnet. Selbstverständlich ist es auch möglich, zuerst den Wandungsdurchbruch 9 in den Halbleiterchip 3 einzubringen und erst danach die Sensoren 4a, 4b in den Halbleiterchip 3 zu integrieren. Deutlich ist erkennbar, dass in dem Halbleiterchip 3 zwischen den Sensoren 4a, 4b ein schmaler Verformungsbereich 7 gebildet ist, der als Torsionssteg dient. Die Sensoren 4a, 4b werden um die Längsachse 10 des Torsionsstegs in Richtung des Doppelpfeils 11 relativ zueinander verschwenkt und dann in einer vorbestimmten Lage relativ zueinander fixiert. Es ist aber auch möglich, den von dem Wandungsdurchbruch 9 umgrenzten Sensor 4a relativ zu dem anderen Sensor 4b zum Schwingen um die Längsachse 10 des Torsionsstegs anzuregen. Dabei können während des Schwingens Messwerte mit den Sensoren 4a, 4b erfasst werden.

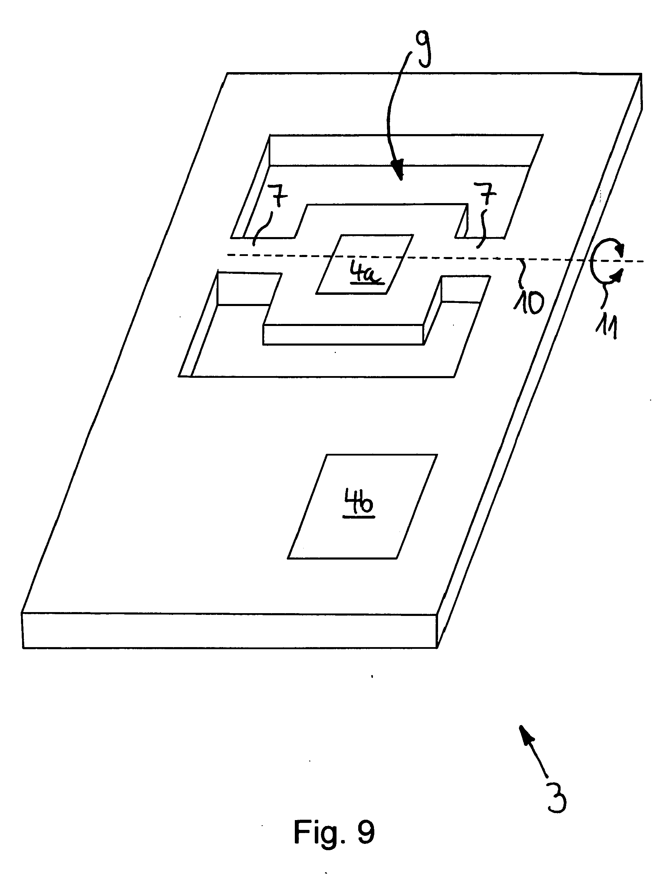

Wie in Fig. 9 erkennbar ist, kann der erste Sensor 4a auch an zwei jeweils als Torsionssteg ausgestalteten Verformungsbereichen 7 relativ zu dem zweiten Sensor 7b verschwenkbar gelagert sein. Dabei sind die Verformungsbereiche 7 beidseits des ersten Sensors 4a mit ihren Längsachsen in gerader Verlängerung zueinander angeordnet.

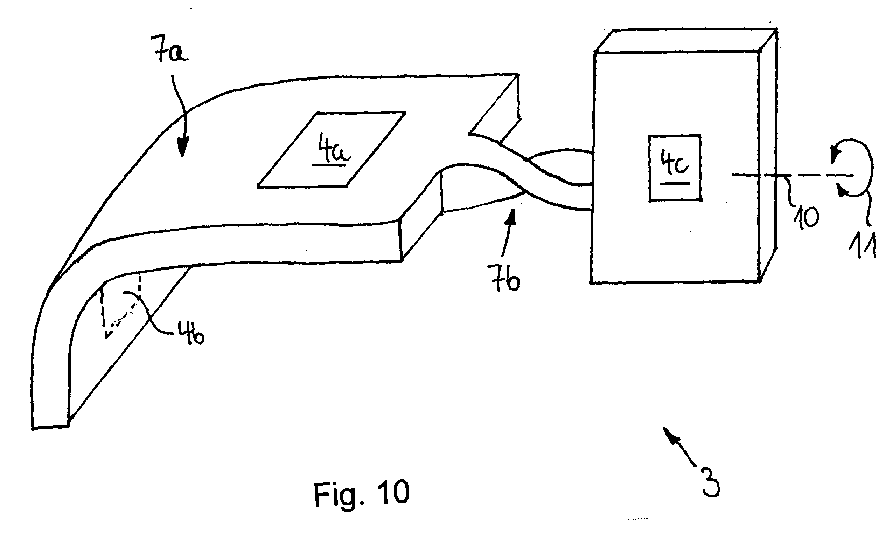

Bei dem in Fig. 10 gezeigten Ausführungsbeispiel sind in den Halbleiterchip 3 drei direktionale Sensoren 4a, 4b, 4c integriert. Zwischen einem ersten Sensor 4a und einem zweiten Sensor 4b ist ein erster Verformungsbereich 7a und zwischen dem ersten Sensor 4a und einem dritten Sensor 4c ein zweiter Verformungsbereich 7b angeordnet. Bei der Herstellung des Halbleiterbauelements 1 wird der erste Verformungsbereich 7a um eine in der Ebene des Halbleiterchips 3 oder etwa parallel dazu verlaufende Achse gekrümmt und der zweite, als Torsionssteg ausgestaltete Verformungsbereich um dessen Längsachse 10 in Richtung des Doppelpfeils 11 tordiert. Somit zeigen alle drei Sensoren 4a, 4b, 4c in unterschiedliche Richtungen. Die Sensoren 4a, 4b, 4c können kardanisch aufgehängt oder in einer vorbestimmten Lage relativ zueinander fixiert sein. Wenn die Sensoren 4 Magnetfeld-Sensoren sind, ermöglicht das Bauelement eine dreidimensionale Messung eines Magnetfelds. Die Sensoren 4 können auch als Beschleunigungs- und/oder Winkelbeschleunigungssensoren vorgesehen sein. In diesem Fall sind die Sensoren 4 bevorzugt in einem konstanten Magnetfeld angeordnet und anhand der bei einer Beschleunigung des Sensors 4 auftretenden Lageänderung des Sensors 4 relativ zum Magnetfeld und der damit einhergehenden Messsignaländerung wird die Beschleunigung ermittelt.

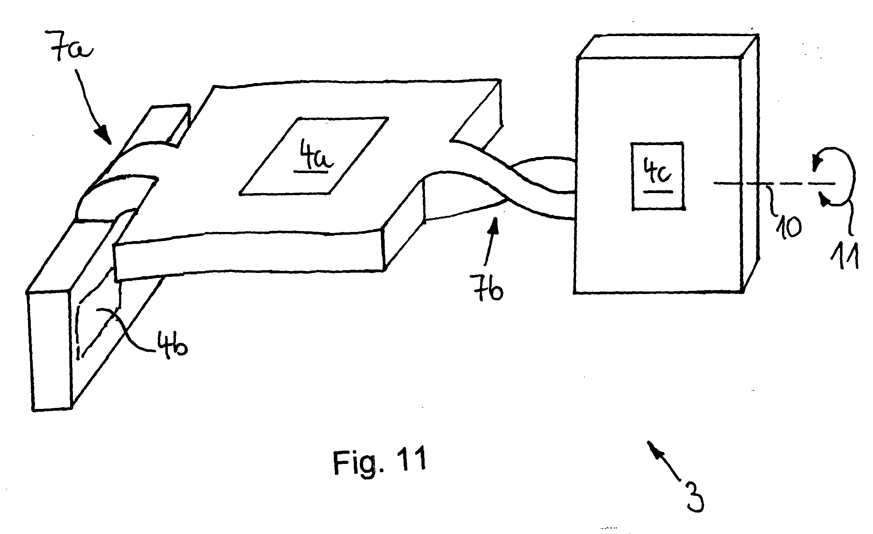

Bei dem in Fig. 11 gezeigten Ausführungsbeispiel ist der Verformungsbereich 7a stegförmig ausgestaltet und quer zur Ebene des Halbleiterchips 3 aus dieser heraus gebogen. Im Übrigen entspricht das in Fig. 11 gezeigte Ausführungsbeispiel dem Ausführungsbeispiel gemäß Fig. 10.

## Patentansprüche

1. Verfahren zum Herstellen eines Halbleiterbauelements (1), das mindestens zwei Sensoren (4, 4a, 4b, 4c) aufweist, wobei ein sich zunächst in einer Ebene erstreckender Halbleiterchip (3) bereitgestellt wird, **dadurch gekennzeichnet, dass** die Sensoren (4, 4a, 4b, 4c) mit Abstand zueinander in den Halbleiterchip (3) integriert sind, dass zumindest in einem zwischen den Sensoren (4, 4a, 4b, 4c) befindlichen Verformungsbereich (7) des Halbleiterchips (3) der Querschnitt des Halbleiterchips (3) derart gewählt wird, dass der Verformungsbereich (7) biegeverformbar ist, dass die Sensoren (4, 4a, 4b, 4c) mit ihren Erstreckungsebenen unter Biegeverformung des Verformungsbereichs (7) relativ zueinander verschwenkt und/oder verkippt und/oder verdreht und/oder mit Ihren Erstreckungsebenen parallel zueinander versetzt werden.

2. Verfahren nach Anspruch 1, **dadurch gekennzeichnet, dass** die Sensoren (4, 4a, 4b, 4c) in der verschwenkten, verkippten, verdrehten und/oder parallel zueinander versetzten Lage relativ zueinander fixiert werden.

3. Verfahren nach Anspruch 1 oder 2, **dadurch gekennzeichnet, dass** die Sensoren (4, 4a, 4b, 4c) in der verschwenkten, verkippten, verdrehten und/oder parallel zueinander versetzten Lage derart angeordnet werden, dass sie sich unter dem Einfluss einer Kraft in verschiedene Richtungen relativ zueinander verdrehen und/oder zu Schwingungen angeregt werden können.

4. Verfahren nach einem der Ansprüche 1 bis 3, **dadurch gekennzeichnet, dass** der Winkel, um den die Sensoren (4, 4a, 4b, 4c) relativ zueinander verschwenkt, verkippt und/oder verdreht werden, betragsmäßig größer ist 0,5°, insbesondere größer als 3°, gegebenenfalls größer als 5° und bevorzugt größer als 10°.

5. Verfahren nach einem der Ansprüche 1 bis 4, **dadurch gekennzeichnet, dass** der Halbleiterchip (3) eine längliche, vorzugsweise rechteckige Form aufweist, dass die Sensoren (4, 4a, 4b, 4c) in Längserstreckungsrichtung des Halbleiterchips (3) voneinander beabstandet sind, und dass die Sensoren (4, 4a, 4b, 4c) derart verschwenkt verkippt und/oder verdreht werden, dass mindestens drei Sensoren (4, 4a, 4b, 4c) auf einer von einer geraden Linie abweichenden Linie, insbesondere auf einer Kreislinie angeordnet sind.

6. Verfahren nach einem der Ansprüche 1 bis 5, **dadurch gekennzeichnet, dass** mindestens drei Sensoren (4a, 4b, 4c) in den Halbleiterchip integriert sind, dass zwischen einem ersten Sensor (4a) und einem zweiten Sensor (4b) ein erster Verformungsbereich (7a) und zwischen dem ersten Sensor (4a) und einem dritten Sensor (4c) ein zweiter Verformungsbereich (7b) erzeugt werden, und dass der erste Sensor (4a) und der zweite Sensor (4b) durch Biegeverformen des ersten Verformungsbereichs (7a) um eine erste Achse (9a) relativ zueinander verschwenkt werden, und dass der erste Sensor (4a) und der dritte Sensor (4c) durch ßiegeverformen des zweiten Verformungsbereichs (7a) um eine zweite, quer zu der ersten Achse (9a) verlaufende Achse (9b) relativ zueinander verschwenkt werden

7. Verfahren nach einem der Ansprüche 1 bis 6, **dadurch gekennzeichnet, dass** ein Wafer (2) bereitgestellt wird, der mehrere einstückig miteinander verbundene Halbleiterchips (3) hat, die jeweils mindestens zwei Sensoren (4, 4a, 4b, 4c) und wenigstens einen Verformungsbereich (7) aufweisen, und dass die Halbleiterchips (3) von dem Wafer (2) abgetrennt werden, bevor die Sensoren (4, 4a, 4b, 4c) der einzelnen Halbleiterchips (3) mit ihren Erstreckungsebenen unter Biegeverformung des Verformungsbereichs (8) relativ zueinander verschwenkt, verkippt und/oder verdreht werden.

8. Verfahren nach einem der Ansprüche 1 bis 7, **dadurch gekennzeichnet, dass** die Wandstärke des Wafers (2) im Bereich der Halbleiterchips (3) gegenüber einem daran angrenzenden Waferbereich reduziert wird und dass die Halbleiterchips (3) entlang der Außenkonturen der die reduzierte Wandstärke aufweisenden Bereiche des Wafers (2) aus diesem herausgetrennt werden.

9. Verfahren nach einem der Ansprüche 1 bis 8, **dadurch gekennzeichnet, dass** der Halbleiterchip (3) planar auf einem Frame angeordnet wird und das Frame danach zusammen mit dem Verformungsbereich (7) des Halbleiterchips (3) verbogen wird.

10. Halbleiterbauelement (1) mit mindestens zwei mit Abstand zueinander angeordneten Sensoren (4, 4a, 4b, 4c), die mit ihren Erstreckungsebenen verkippt zueinander an einem Träger (6) angeordnet sind, **dadurch gekennzeichnet, dass** die Sensoren (4, 4a, 4b, 4c) in denselben Halbleiterchip (3) integriert sind, und dass der Halbleiterchip (3) zumindest zwischen den Sensoren (4, 4a, 4b, 4c) einen Verformungsbereich (7) aufweist, der einen von einer geraden Ebene abweichenden, gekrümmten Verlauf ermöglicht und die Sensoren (4, 4a, 4b, 4c) direkt oder indirekt über mindestens einen ebenen Halbleiterbereich einstückig miteinander verbindet.

11. Halbleiterbauelement (1) nach Anspruch 10, **dadurch gekennzeichnet, dass** die Sensoren (4, 4a, 4b, 4c) an dem Träger in ihrer Lage relativ zueinander fixiert sind.

12. Halbleiterbauelement (1) nach Anspruch 10 oder 11, **dadurch gekennzeichnet, dass** die Sensoren (4, 4a, 4b, 4c) an dem Träger relativ zueinander bewegbar angeordnet sind.

13. Halbleiterbauelement (1) nach einem der Ansprüche 10 bis 12, **dadurch gekennzeichnet, dass** der Halbleiterchip (3) eine längliche, vorzugsweise rechteckige Form aufweist, dass mindestens drei Sensoren (4, 4a, 4b, 4c) in Längserstreckungsrichtung des Halbleiterchips (3) voneinander beabstandet und auf einer von einer geraden Linie abweichenden Linie, insbesondere auf einer Kreislinie angeordnet sind.

14. Halbleiterbauelement (1) nach einem der Ansprüche 10 bis 13, **dadurch gekennzeichnet, dass** der Halbleiterchip (3) im Bereich der Sensoren (4, 4a, 4b, 4c) eine größere Wandstärke aufweist als in dem Verformungsbereich.

15. Halbleiterbauelement (1) nach einem der Ansprüche 10 bis 14, **dadurch gekennzeichnet, dass** mindestens zwei Sensoren (4, 4a, 4b, 4c) über einen als Torsionssteg ausgestalteten Verformungsbereich (7) miteinander verbunden sind.

16. Halbleiterbauelement (1) nach einem der Ansprüche 10 bis 15, **dadurch gekennzeichnet, dass** der Träger (6) einen dem Verlauf des Halbleiterchips (3) folgenden, gekrümmten Verlauf aufweist und an mehreren voneinander beabstandeten Stellen dieses Verlaufs an dem Halbleiterchip (3) zur Anlage kommt.

17. Halbleiterbauelement (1) nach einem der Ansprüche 10 bis 16, **dadurch gekennzeichnet, dass** der Halbleiterchip (3) mindestens drei Sensoren (4a, 4b, 4c) aufweist, dass zwischen einem ersten Sensor (4a) und einem zweiten Sensor (4b) ein erster Verformungsbereich (7a) und zwischen dem ersten Sensor (4a) und einem dritten Sensor (4c) ein zweiter Verformungsbereich (7b) angeordnet sind, und dass der erste Sensor (4a) und der zweite Sensor (4b) mit ihren Erstreckungsebene quer zueinander und jeweils quer zur Erstreckungsebene des dritten Sensors (4c) angeordnet sind.

18. Halbleiterbauelement nach einem der Ansprüche 10 bis 17, **dadurch gekennzeichnet, dass** in den Halbleiterchip eine Auswerte- und/oder Ansteuereinrichtung integriert ist, die über in den Halbleiterchip integrierte elektrische Verbindungsleitungen mit den Sensoren verbunden ist.

19. Halbleiterbauelement nach einem der Ansprüche 10 bis 18, **dadurch gekennzeichnet, dass** der Träger ein Teil eines Frames ist, der mehrere voneinander beabstandete elektrisch leitende Teilbereiche aufweist die mit Anschlussstellen des Halbleiterchips elektrisch verbunden sind.
